(19) **Europäisches Patentamt / European Patent Office / Office européen des brevets**

(11) **EP 2 025 055 B1**

(12) **EUROPEAN PATENT SPECIFICATION**

(45) Date of publication and mention
of the grant of the patent:
**09.12.2009 Bulletin 2009/50**

(21) Application number: **07735939.6**

(22) Date of filing: **16.05.2007**

(51) Int Cl.:
***H03D 7/14*** *(2006.01)*

(86) International application number:
**PCT/IB2007/051875**

(87) International publication number:
**WO 2007/135633 (29.11.2007 Gazette 2007/48)**

(54) **CALIBRATION STRATEGY FOR REDUCED INTERMODULATION DISTORTION**

KALIBRIERUNGSSTRATEGIE FÜR EINE REDUZIERTE INTERMODULATIONSVERZERRUNG

STRATÉGIE D'ÉTALONNAGE POUR UNE DISTORSION D'INTERMODULATION RÉDUITE

(84) Designated Contracting States:
**DE FR GB IT**

(30) Priority: **23.05.2006 EP 06114368**

(43) Date of publication of application:
**18.02.2009 Bulletin 2009/08**

(73) Proprietor: **NXP B.V.**
**5656 AG Eindhoven (NL)**

(72) Inventor: **BIRTH, Winfrid**
**NL-5656 AG Eindhoven (NL)**

(74) Representative: **Maccalli, Marco et al**
**Maccalli & Pezzoli S.r.l.,**
**Via Settembrini, 40**
**20124 Milano (IT)**

(56) References cited:
**WO-A-98/43357      WO-A-2005/112251**

- **HOFTI M ET AL: "Dual-mode direct-conversion RF receiver with IIP2 calibration" COMPOUND SEMICONDUCTOR INTEGRATED CIRCUIT SYMPOSIUM, 2004. IEEE MONTEREY, CA, USA OCT. 24-27, 2004, PISCATAWAY, NJ, USA,IEEE, 24 October 2004 (2004-10-24), pages 183-186, XP010767460 ISBN: 978-0-7803-8616-7**
- **HOTTI M ET AL: "An IIP2 calibration technique for direct conversion receivers" CIRCUITS AND SYSTEMS, 2004. ISCAS '04. PROCEEDINGS OF THE 2004 INTERNA TIONAL SYMPOSIUM ON VANCOUVER, BC, CANADA 23-26 MAY 2004, PISCATAWAY, NJ, USA,IEEE, US, 23 May 2004 (2004-05-23), pages 257-260, XP010719784 ISBN: 978-0-7803-8251-0 cited in the application**
- **CHANG M-C F ET AL: "A CMOS Passive Mixer With Low Flicker Noise for Low-Power Direct-Conversion Receiver" IEEE JOURNAL OF SOLID-STATE CIRCUITS, IEEE SERVICE CENTER, PISCATAWAY, NJ, US, vol. 40, no. 5, 1 May 2005 (2005-05-01), pages 1084-1093, XP011131306 ISSN: 0018-9200 cited in the application**

**Description**

The present invention generally relates to a circuit and method for reducing the 2nd order intermodulation distortion in a non-linear device having a differential output stage. In particular, the present invention relates to a trimming strategy for improving an intermodulation intercept point second order (IIP2) in an active or passive mixer.

When a carrier signal or the like is modulated by or mixed with another signal of different frequency, non-linearity of the respective processing device, e.g., mixer, causes undesired output frequencies which are different from the input frequencies. Namely, when input signals having two or more frequencies are mixed together, distortion is produced, i.e., intermodulation distortion (IMD) having additional undesired frequencies. In case of second order distortions, the frequencies of intermodulation components correspond to the sum of the two input frequencies and the difference between the two input frequencies. Thus, when two input signals having two different input frequencies are applied to the non-linear device, the intermodulation distortion product IM2 that happens at the difference frequency of two test tones.

The signal strength of two test tones outputTestTones[dBV] and the unwanted product IM2[dBV] can be measured at the output of a DUT (Device Under Test). Additionally it is known which power of test tones pwrINPUT[dBm] is applied at the DUT.

Further, the term losses[dB] represents the attenuation of test tones by the DUT. With this data the second order Input Intersept Point IIP2 of the DUT is defined as follows.

$$IIP2[dBm] = outputTestTones[dBV] - IM2[dBV] + pwrINPUT[dBm]$$
$$+ losses[dB]$$

This value IIP2 remains constant over a wide range of applied input power.

The IIP2 is an important parameter used to characterize a radio frequency (RF) communication system and represents a special kind of non-linearity of the communication system. The value of the intercept point decreases with increased non-linearity of the system and vice versa. IIP2 is high if the symmetry of a system is good. A very nonlinear system with high symmetry may have a good IIP2. A further expression characterizes the linearity. It is called IIP3. The IIP3 is not regarded and not needed for the parameter IIP2.

For a mixer in a receiver a high IIP2 is required. An IIP2 calibration or trimming circuit for adjusting the IIP2 is necessary.

In M. Hotti et al., "An IIP2 Calibration Technique for Direct Conversion Receivers", ISCAS 2004, IEEE, pages IV-257 to 260, an improvement for a IIP2 calibration method for a Gilbert cell type mixer is described. A high IIP2 is maintained over the entire base band channel in wide band systems, while detection of a correct trimming code is provided to implement an on-chip tuning engine. The criteria for trimming are the DC voltage steps at the mixer output caused by a signal from the transmitter. However, an ideal trimming is not possible due to the poor accuracy of measuring the DC steps. Moreover, the proposed solution leads to a significant loss of DC headroom, while a change of DC headroom contributes a lot to IIP2 trimming.

Additionally, S. Zhou et al., "A CMOS Passive Mixer with Low Flicker Noise for Low-Power Direct-Conversion Receiver", IEEE, Solid-State Circuits, VOL. 40; No. 5; May 2005 discloses an IIP2 trimming circuit for passive mixers, where DC offset at mixer gates is trimmed for best IIP2. However, a very complex circuitry is required to provide the desired trimming capability.

Furthermore, chopper stabilization of IIP2 is suggested in E. Bautista, "A High IIP2 Down Conversion Mixer Using Dynamic Matching", IEEE, Solid-State Circuits; VOL. 35, No. 12; Dec 2000. However, the chopper frequency introduces risk of spurious responses.

In addition thereto, the US 2005/0143044 A1 discloses a circuit for calibrating IIP2 and for reducing second order intermodulation, which includes a common mode feedback circuit and a load impedance operatively connected between first and second output terminals of a mixer in a direct conversion receiver. The common mode feedback circuit reduces second order intermodulation of the mixer by detecting an output voltage of the mixer and adjusting a gain of the mixer. The IIP2 is controlled by controlling the gain of the common mode feedback circuit. Common-mode signal parts are used for IIP2 calibration.

In document WO 2005/112251 the intermodulation distortion in a non-linear device having a differential output stage is reduced by adjusting a load impedance by calibration.

It is an object of the present invention to provide a calibration or trimming circuit and method, which are suitable for low voltage, high frequency applications.

This object is achieved by a circuit as claimed in claim 1 and by a method as claimed in claim 11.

In the circuit, IIP2 is trimmed by introducing an asymmetry of a transistor pair, e.g., through a bulk voltage asymmetry.. This is applicable for active and for passive mixers. Active mixers need a DC supply current with a voltage drop at transistors, passive mixers not. Transistors at passive mixers are ohmic switches only. IIP2 at passive mixers depends on symmetry at On- and OFF-resistances and on symmetry of the load impedance. For active mixers there is additionally the need for symmetry of voltages at the transistors, e.g. between drain and source. This requirement is also used in the present invention for the option to trim IIP2 by trimmed differences at supply voltages for a transistor pair from an active mixer. Different voltages at a transistor pair change the symmetry as well. The present invention can be applied for single-balanced mixers or for double- balanced mixers or for simple symmetrical active gain stages.

Accordingly, by adding a calibration offset voltage to the output branch or applying it to a bulk terminal of a transistor connected to the output branch, a certain degree of asymmetry is introduced in a simple manner, so that both output branches of the differential output stage are matched or optimized to improve the IIP2 factor and reduce intermodulation distortions.

The calibration offset voltage may be obtained in different manners, reflecting different aspects of the present invention.

According to a first aspect, memory means may be provided for storing a plurality of offset voltage values of the differential output branch, wherein the circuit is adapted to select as the calibration offset voltage an offset voltage value which is associated with a minimum value of the related output values. As an example, the related output values may correspond to second order intermodulation products. Thereby, an easy solution to the above problem can be provided, wherein second order intermodulation (IM2) results are stored for different offset voltage values, e.g., during manufacturing of the circuit. Then, during application, the stored offset voltage value which led to the minimum IM2 result is applied.

According to a second aspect, the offset voltage at an output of the differential output stage is detected and used for generating the calibration offset voltage. In the second aspect, a value of a desired offset voltage may be stored, and the calibration offset voltage is generated at a value required to obtain the stored value at the output of the differential output stage.

According to a third aspect, a value of the calibration offset voltage, which may have been determined during circuit evaluation, is stored, and - during circuit application - the calibration offset voltage is generated at a value corresponding to the stored value. This solution is preferable for passive mixers or other passive circuits, where no DC current is provided in the switches of the output branches. Moreover, this solution is feasible if large transistors are used in mixers with low power.

Further advantageous developments are defined in the dependent claims.

The present invention will now be described based on preferred embodiments with reference to the accompanying drawings in which:

Fig. 1 shows a schematic block diagram of a calibration circuit according to the preferred embodiments;
Fig. 2 shows a schematic circuit diagram of an active mixer with IIP2 calibration according to a first preferred embodiment;
Fig. 3 shows a schematic circuit diagram of a passive mixer circuit with IIP2 calibration according to a second preferred embodiment;
Fig. 4 shows a diagram indicating IIP2 values vs. bulk voltage values for a passive mixer;
Fig. 5 shows a diagram indicating IIP2 trimming by bulk offset voltage;
Fig. 6 shows a flow diagram of a calibration method; and
Fig. 7 shows a schematic circuit diagram of a mixer circuit with IIP2 calibration according to a third preferred embodiment.

In the following, the preferred embodiments are described on the basis of mixer circuits with differential output stage, such as a double balanced mixer.

Second order distortion in the mixer produces a static DC offset at the output of the mixer as well as local oscillator (LO) self-mixing. Therefore, by minimizing the change in the DC offset, it is possible to detect the correct trimming or calibration state. However, it is noted that the DC offset at the mixer output is a cumulative offset comprising static DC offset due to self-mixing and device mismatch. Therefore, optimum calibration is achieved when the DC offset caused by the second order intermodulation distortion is minimized. The typical DC offset from LO self-mixing is 60dB larger than the DC offset from IIP2. Only DC offsets and possible DC offset steps must be kept small that are caused at cases of bad IIP2. A constant DC offset in no problem.

According to the preferred embodiments, two possibilities are suggested for IIP2 trimming or calibration. According to the first possibility, the output offset voltage can be calibrated or trimmed by adding an offset voltage in an output branch of the differential l output stage of the mixer circuit in order to obtain an asymmetry until IIP2 is compensated. As an alternative or additional second possibility, the voltage applied at a bulk terminal of a transistor in an output branch of the differential output stage can be calibrated or trimmed until IIP2 is optimized.

A criteria for trimming or calibration can be the output DC offset of the mixer circuit as far as this output is not the above static DC offset due to self-mixing or device mismatch. This criteria is specially suitable for active mixer circuits, such as the Gilbert cell, where the output DC offset is about 1000 times larger than for passive mixer circuits.

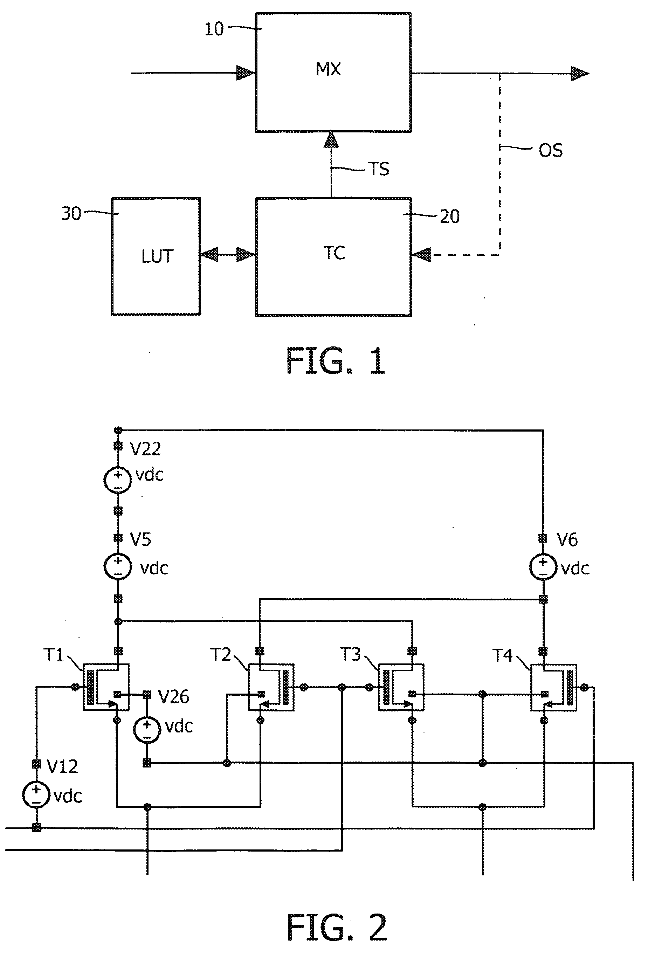

Fig. 1 shows a schematic block diagram of a calibration arrangement according to the preferred embodiments. A calibrating or trimming circuit 20 applies a trimming signal TS to a mixer circuit 10 in order to minimize second order intermodulation distortion to optimize IIP2. The trimming signal TS is an offset voltage applied (case 1) to the differential output stage of the mixer circuit 10 in order to introduce an asymmetry required to obtain a desired DC offset at the output of the mixer circuit 10. The application of the offset voltage may be achieved by adding the offset voltage at the input- or at the output-branch and/or (case 2) by applying the output voltage to a bulk terminal of a transistor connected to the output branch, e.g., of the mixer circuit 10.

The trimming circuit 20 may be adapted to read input values for generating the trimming signal TS from a memory, e.g., a look-up table 30, connected thereto. Additionally, as an optional measure, the output signal OS of the mixer circuit 10 may be fed back to the trimming circuit 20 in order to provide a feedback loop used for continuously adapting the trimming signal TS to changes in the output signal OS of the mixer circuit 10. The feedback path (as indicated by the dotted arrow in Fig. 1) may as well be used for directly measuring or detecting the DC offset at the output of the mixing circuit 10 in order to provide an additional input value to the trimming circuit 20.

Fig. 2 shows a schematic circuit diagram of an active mixer (Gilbert cell) with IIP2 calibration according to the first preferred embodiment. It is noted that in Fig. 2, only the circuit portion relating to the differential output branch of the active mixer is shown, while other circuit portions, such as a local oscillator driver, trans-impedance circuit, and a foot portion of the Gilbert cell have been omitted to reduce complexity.

As can be gathered from Fig. 2, a first offset voltage is applied at a connection point V26 at the bulk terminal of the left transistor to control asymmetry of the differential output branches. As an additional or alternative option, a second offset voltage is applied at the connection point V22, so as to add an offset voltage to the left output branch. The voltage sources indicated at connection points V5 and V6. represent current-to-voltage converter outputs and could thus be replaced by resistor symbols or corresponding current-to-voltage circuits.

Either the offset voltage provided at connection point V22 or the offset voltage provided at connection point V26 are used for IIP2 compensation. The respective non-used offset voltage may be set to zero. However, the two compensation offset voltages at connection points V22 and V26 may as well be used in combination, if desired.

It is noted that the voltage sources indicated in Fig. 2 are of a mere symbolic nature and represent any voltage generation circuitry suitable for generating and applying a desired compensation voltage. As an example, such a voltage generation circuit may consist of at least one resistor to which a current from a digital-to-analog converter (DAC) is applied to generate the required offset voltage. Thereby, the applied or added offset voltage can be controlled simply by applying a digital control word to the DAC. Of course, there are other suitable alternatives (e.g., based on resistor networks, operational amplifiers, and/or active or passive semiconductor elements) for generating and applying or adding the proposed offset voltages. This applies to any cases in the following description, where a simple symbol of a voltage source is shown to represent voltage generation circuits.

As already mentioned, the application of the proposed offset voltage to the bulk terminal of the left transistor T1 and/or the addition of the proposed offset voltage to the left output branch leads to an asymmetry between the two branches to thereby generate a desired output offset of the Gilbert cell, required to minimize second order intermodulation distortions and optimize IIP2.

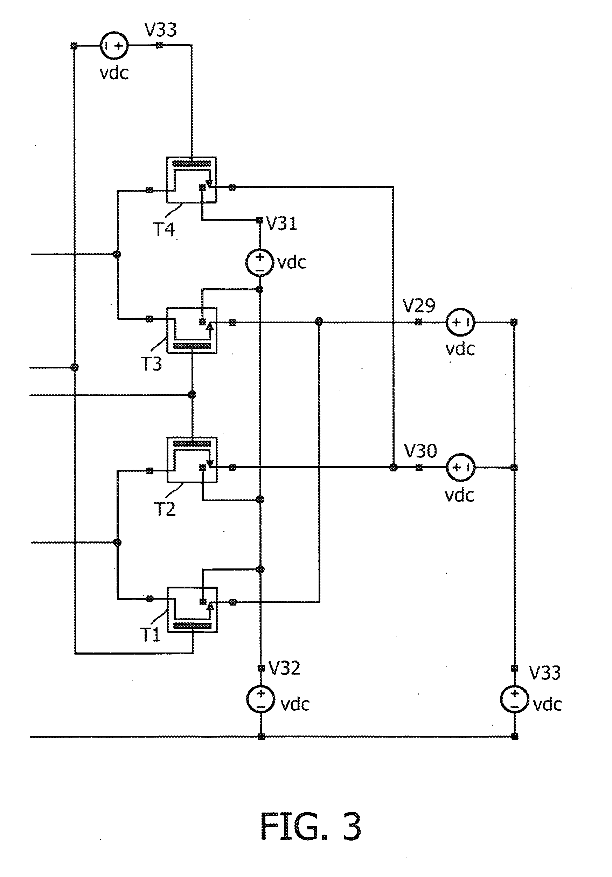

Fig. 3 shows a schematic circuit diagram of a passive mixer circuit with IIP2 compensation according to the second preferred embodiment, where - again - parts of the whole mixer circuits have been omitted for reasons of clarity and brevity. In particular, an active trans-impedance circuit has been omitted at the mixer output, which serves to fix the output. Furthermore, the orientation of the transistors T1 to T4 is changed from a vertical to a horizontal direction. Connection point V33 provides a constant DC operation voltage for the complete passive circuitry that does not need a DC supply current. The output voltages at V29 and V30 are control voltages at an active trans-impedance circuit. Thus the mixer outputs are virtual grounds at an operational amplifier circuitry. The two DC voltage sources at V29 and V30 are thus not actually provided and just represent voltage sources which may be used for simulation purposes.

In the circuit of Fig. 3, an average bulk voltage is applied at connection point V32 and an additional compensation offset voltage is applied at connection point V31. Thus, the transistors T 1 to T3 have the average bulk voltage applied at their bulk terminals, while the transistor T4 has the additional compensation offset voltage applied at its bulk terminal, in addition to the average bulk voltage. The compensation offset voltage at connection point V31 serves to compensate for errors caused by an offset threshold voltage due to device mismatch or due to local oscillator (LO) self-mixing.

The so-called amplitude modulation (AM) interferer test may be used for type approval. A modulation signal more than 6 MHz apart from the RF carrier frequency jumps in power to -31 dBm. The wanted RF signal is set 3 dB above reference sensitivity. A DC-step appears at about the midamble of a wanted RX burst. In cases of good IIP2 compensation, output DC steps are in the order of 5 $\mu$V and, for bad compensation of IIP2, in the order of up to 100 $\mu$V at the symmetrical output of the trans-impedance circuit behind the mixer. DC currents are asymmetrical for a case of bad IIP2 compensation of the active mixer of Fig. 2. This current asymmetry causes a DC output offset voltage that is about 1000 times larger than the above small DC step. Therefore, as already mentioned above, the output offset of the mixer can be used as a criteria for IIP2 calibration or trimming.

In the case of the active mixer circuit of Fig. 2, a trimming or calibration strategy may be to measure the output voltage offset for trimmed good IIP2 calibration. Then, typical cases are calculated during the evaluation phase of the die and the values are stored in the look-up table 30 of Fig. 1. Now, during application of the active mixer circuit, the trimming circuit 20 calibrates the offset voltage for the goal or target value stored in the look-up table 30. A required accuracy for measurements of the automatic trimming circuit 20 may be in the order of 2 mV.

In case of the passive mixer of Fig. 3, the following trimming or calibration strategy can be used. Here, fairly no correlation is provided between IIP2 and a rather strong DC current asymmetry, because there is no DC current in the switches of the passive mixer. If the offset bulk voltage is trimmed at the passive mixer, the overall output DC offset is moved only little, e.g., by +/-5 $\mu$V. Consequently, in view of the additional large offset resulting from LO self-mixing, it is difficult to filter DC offset changes from the noise background.

It is therefore proposed to fix typical compensation offset voltage values after the evaluation phase and reuse them during application without any further measurements. This can be feasible if large transistors are used in the passive mixer.

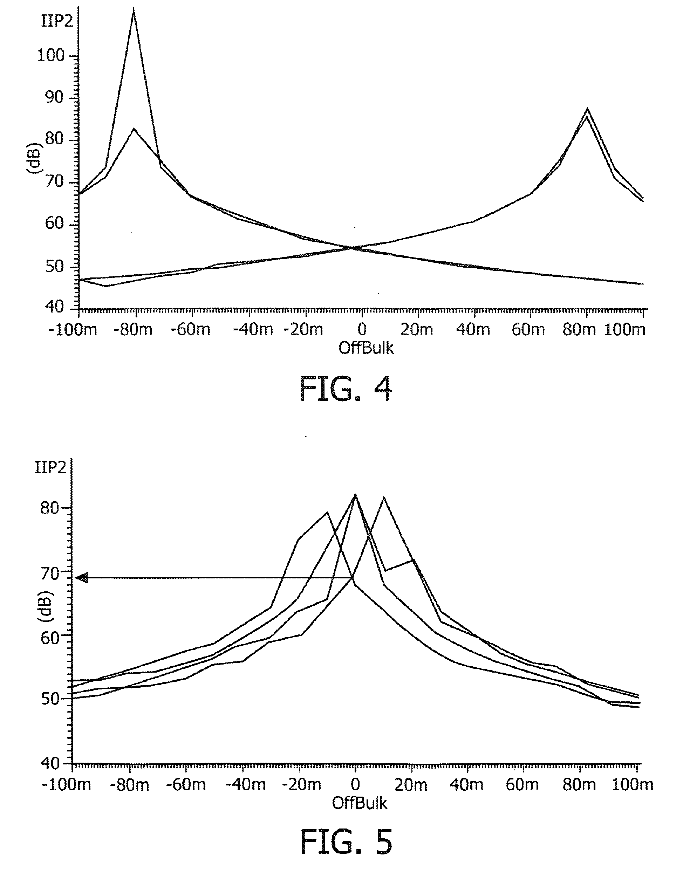

Fig. 4 shows a diagram indicating IIP2 values in dB over voltage values of the bulk offset voltage in the case of a passive mixer as shown in Fig. 3. In the underlying measurements, the bulk offset voltage is trimmed from -100 mV to +100 mV and the threshold offset voltage applied at connection point V33 is set to -10 mV and +10 mV. LO self-mixing is not considered here. The two curves with their peaks on the right-hand side relate to the offset voltage of-10 mV, while the upper curve relates to a receiving power at the antenna of-43 dBm and the lower curve relates to a receiving power at the antenna of-31 dBm. The two curves with their peaks at the left-hand side relate to the offset threshold voltage of 10 mV, while the upper curve relates to a receiving power at the antenna of-31 dBm and the lower curve to a receiving power at the antenna of-43 dBm. Thus, it can be seen from Fig. 4 that bulk trimming results do not depend on the power level of the applied two-tone test, but merely on the offset threshold voltage.

Fig. 5 shows a diagram indicating IIP2 versus bulk offset voltage value for the same range as in Fig. 4, but with strong LO self-mixing as the influence. The case relates to a two-tone test at an antenna power level of-43 dBm with an offset threshold voltage of 0 V and a parasitic local oscillator of 30 $\mu$A at the RF input of the passive mixer circuit for about 90° plus the phases 0°, 90°, 180° and 270°.

The curve with the peak on the left-hand side relates to 90°, and the curve with the peak on the right-hand side relates to 270°. The two curves with the peak in the center relate to 0° and 180°, while the lower one of these curves relates to 0°. The arrow indicates the robustness of the passive mixer against LO self-mixing.

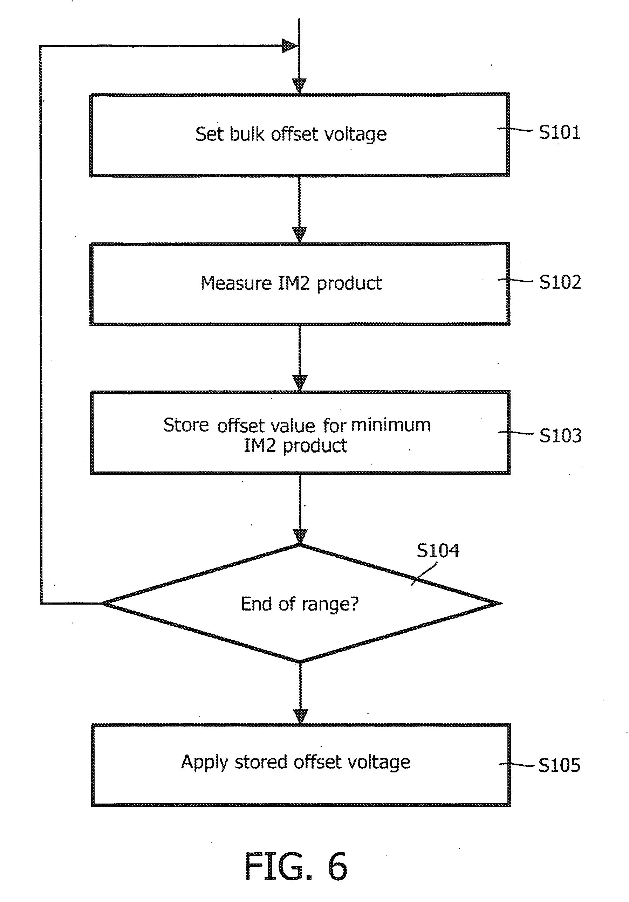

Fig. 6 shows a schematic flow diagram of a further trimming or calibration strategy usable for both kinds of mixers, e.g., as shown in Figs. 2 and 3, wherein the IM2 product obtained at the output of the mixer is minimized after a two-tone measurement.

Similar to Figs. 4 and 5, the bulk offset voltage is change from -100 mV to +100 mV and the obtained IM2 products (e.g. IIP2) are stored in the look-up table or memory 30 of Fig. 1. After this initial measurement, the value of the bulk offset voltage for the minimum IM2 product (i.e. maximum IIP2) is applied during application of the mixer circuit.

In step S101, a bulk offset voltage is set and the IM2 product is measured in step S102. Then, in the example of Fig. 6, the respective offset value is stored if it relates to the minimum IM2 product, i.e. if the IM2 product is the smallest of all values obtained so far. (Step S103). Then, in step S 104 it is checked whether the end of the range of bulk offset voltage values has been reached. If not, the procedure returns to step S101 and selects the next bulk offset voltage. On the other hand, if it is determined in step S104 that the end of range has been reached, the stored offset voltage corresponds to the minimum IM2 product and is applied by the calibration circuit 20 of Fig. 1 (step S105).

Of course, step S103 can be modified in a sense that all offset values are stored together with their associated IM2 products. Then, step S105 is amended to include a selection operation for selecting the stored offset voltage with the minimum associated IM2 product. Then, the number of storage operations is however increased, as each individual processing loop includes a storing operation.

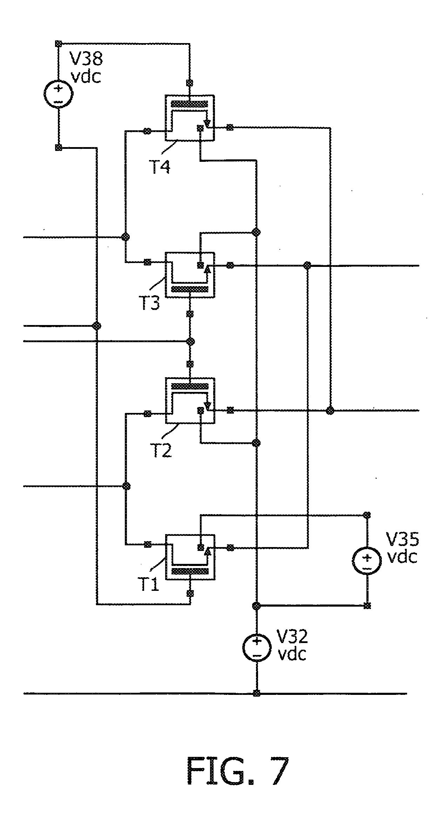

Fig. 7 shows a schematic circuit diagram of a portion of a mixer circuit according to the third preferred embodiment, similar to Fig. 3, where the bulk offset voltage is however applied at a connection point V35 and thus at the left transistor T1. Accordingly, the asymmetry is introduced at the left output branch to which the transistors T1 and T2 are connected.

The above mixer circuits may be implemented in a 2 V technology in case of the active Gilbert cell and in a 1 V technology in case of the passive mixer. In the circuit diagrams of Figs. 2, 3, and 7, the introduction of the threshold offset voltage at one transistor pair is used to simulate a bad IIP2 situation. However, in both cases it is possible to compensate the bad IIP2 by trimming the bulk voltage of one transistor, and/or by adding an offset voltage to the respective output branch in case of the active mixer circuit of Fig. 2. The proposed bulk trimming for optimization of IIP2 may be used for passive and active circuits. In case of active circuits, IIP2 may as well be calibrated using a desired or predetermined asymmetry of the supply voltages for a transistor pair of the differential output stage. DC offset components (DC Stepp) of active mixer circuits may be used as criteria for IIP2 trimming of a Gilbert cell. This option is possible for Gilbert cells due to the fact that for the signal processing a resolution of 2mV is still high enough for quantization.

In summary, a circuit and method for reducing intermodulation distortion in a non-linear device having a differential output stage have been described. Calibration means are provided for adding a calibration offset voltage to at least one of one output branch of said differential output stage and a bulk terminal of a transistor of one output branch of said differential output stage, to obtain a desired output offset at said differential output stage. Thereby, a certain degree of asymmetry is introduced, so that both output branches of the differential output stage are matched or optimized to improve the IIP2 factor and reduce intermodulation distortions.

It is noted that the present invention is not restricted to the above preferred embodiments and can be used for compensation of any intermodulation distortions in any non-linear device with differential output stage. The preferred embodiments may thus vary within the scope of the attached claims.

Finally but yet importantly, it is noted that the term "comprises" or "comprising" when used in the specification including the claims is intended to specify the presence of stated features, means, steps or components, but does not exclude the presence or addition of one or more other features, means, steps, components or group thereof. Further, the word "a" or "an" preceding an element in a claim does not exclude the presence of a plurality of such elements. Moreover, any reference sign does not limit the scope of the claims.

## Claims

1. A circuit for reducing intermodulation distortion in a non- linear device (10) having a differential output stage, said circuit comprising:

    - offset generating means (20) for generating a calibration offset voltage; and
    - calibrating means (20) for adding said calibration offset voltage to at least one of one output branch of said differential output stage and a bulk terminal of a transistor of one output branch of said differential output stage, in order to obtain a desired output offset at said differential output stage.

2. A circuit according to claim 1, further comprising memory means (30) for storing a plurality of offset voltage values, wherein said circuit is adapted to select as said calibration offset voltage an offset voltage value associated with a minimum related output value.

3. A circuit according to claim 2, wherein said minimum related output value corresponds to a minimum second order intermodulation product.

4. A circuit according to any one of the preceding claims, further comprising detecting means (20) for detecting an offset voltage at an output of said differential output stage.

5. A circuit according to claim 4, further comprising memory means (30) for storing a value of a desired offset voltage, wherein said offset generating means (20) is adapted to read said value of said desired offset voltage and to generate said calibration offset voltage at a value required to obtain said read value at said output offset differential output stage.

6. A circuit according to any one of claims 1 to 4, further comprising memory means (30) for storing a value of said calibration offset voltage, wherein said offset generating means (20) is adapted to read said value of said calibration offset voltage and to generate said calibration offset voltage at a value corresponding to said read value.

7. A circuit according to any one of the preceding claims, wherein said non-linear device is a mixer circuit (10).

8. A circuit according to any one of the preceding claims, wherein said offset generating means (10) comprises resistor means to which a current from a digital-to-analog converter is supplied.

9. A circuit according to any one of the preceding claims, wherein said calibration offset voltage is added to one of the supply voltages of one of the transistors of a transistor pair.

10. A circuit according to claim 9, wherein said calibration offset voltage is added to a Bulk voltage of said one transistor of said transistor pair.

11. A method for reducing intermodulation distortion in a non- linear device (10) having a differential output stage, said method comprising the steps of:

- generating a calibration offset voltage; and
- adding said calibration offset voltage to at least one of one output branch of said differential output stage and a bulk terminal of a transistor of one output branch of said differential output stage, to obtain a desired output offset at said differential output stage.

12. A method according to claim 11, further comprising storing a plurality of offset voltage values, and selecting a said calibration offset voltage an offset voltage value which is associated with the minimum related output value.

13. A method according to claim 12, wherein said minimum related output value corresponds to a minimum second order intermodulation product.

14. A method according to any one of claims 11 to 13, wherein said method is used for trimming an intermodulation intercept point second order (IIP2).

15. A method according to claim 14, further comprising using output DC offset components of active mixer circuits as criterion for trimming said IIP2 of a Gilbert cell.

**Patentansprüche**

1. Schaltung zum Reduzieren von Intermodulationsverzerrung in einem nichtlinearen Bauteil (10) mit einer differenziellen Ausgabestufe, wobei die Schaltung aufweist:

eine Offset-Erzeugungseinrichtung (20) zum Erzeugen einer Kalibrierung-Offset-Spannung; und
eine Kalibrierungseinrichtung (20) zum Hinzufügen der Kalibrierung-Offset-Spannung zu mindestens einem von einem Ausgabezweig der differenziellen Ausgabestufe und einem Bulk-Anschluss eines Transistors eines Ausgabezweiges der differenziellen Ausgabestufe, um einen gewünschten Ausgabe-Offset an der differenziellen Ausgabestufe zu erreichen.

2. Schaltung gemäß Anspruch 1, weiterhin aufweisend eine Speichereinrichtung (30) zum Speichern einer Mehrzahl von Offset-Spannungswerten, wobei die Schaltung eingerichtet ist, als die Kalibrierung-Offset-Spannung einen Offset-Spannungswert auszuwählen, der mit einem minimalen zugehörigen Ausgabewert assoziiert ist.

3. Schaltung gemäß Anspruch 2, wobei der minimale zugehörige Ausgabewert einem minimalen Intermodulationsprodukt zweiter Ordnung entspricht.

4. Schaltung nach einem der vorangehenden Ansprüche, weiterhin aufweisend eine Detektionseinrichtung (20) zum Detektieren einer Offset-Spannung an einem Ausgang der differenziellen Ausgabestufe.

5. Schaltung nach Anspruch 4, weiterhin aufweisend eine Speichereinrichtung (30) zum Speichern eines Werts einer gewünschten Offset-Spannung, wobei die Offset-Erzeugungseinrichtung (20) eingerichtet ist, den Wert der gewünschten Offset-Spannung zu lesen und die Kalibrierung-Offset-Spannung mit einem Wert zu erzeugen, der erforderlich ist, um den gelesenen Wert an dem Ausgang der differenziellen Ausgabestufe zu erreichen.

6. Schaltung nach einem der Ansprüche 1 bis 4, weiterhin aufweisend eine Speichereinrichtung (30) zum Speichern eines Werts der Kalibrierung-Offset-Spannung, wobei die Offset-Erzeugungseinrichtung (20) eingerichtet ist, den Wert der Kalibrierung-Offset-Spannung zu lesen und die Kalibrierung-Offset-Spannung mit einem Wert zu erzeugen, der dem gelesenen Wert entspricht.

7. Schaltung nach einem der vorhergehenden Ansprüche, wobei das nicht-lineare Bauteil eine Mixer-Schaltung (10) ist.

8. Schaltung nach einem der vorhergehenden Ansprüche, wobei die Offset-Erzeugungseinrichtung (10) eine Widerstandseinrichtung aufweist, an die ein Strom von einem Digital-zu-Analog-Konverter angelegt ist.

9. Schaltung nach einem der vorhergehenden Ansprüche, wobei die Kalibrierung-Offset-Spannung zu einer der Versorgungsspannungen von einem der Transistoren eines Transistorpaars hinzugefügt ist.

10. Schaltung nach Anspruch 9, wobei die Kalibrierung-Offset-Spannung zu einer Bulk-Spannung des einen Transistors des Transistorpaars hinzugefügt ist.

11. Verfahren zum Reduzieren von Intermodulationsverzerrung in einem nichtlinearen Bauteil (10) mit einer differenziellen Ausgabestufe, wobei das Verfahren die folgenden Schritte aufweist:

Erzeugen einer Kalibrierung-Offset-Spannung; und
Hinzufügen der Kalibrierung-Offset-Spannung zu mindestens einem von einem Ausgabezweig der differenziellen Ausgabestufe und einem Bulk-Anschluss eines Transistors von einem Ausgabezweig der differenziellen Ausgabestufe, um einen gewünschten Ausgabe-Offset an der differenziellen Ausgabestufe zu erreichen.

12. Verfahren nach Anspruch 11, weiterhin aufweisend:

Speichern einer Mehrzahl von Offset-Spannungswerten und Auswählen eines Offset-Spannungswerts als die Kalibrierung-Offset-Spannung, der mit dem minimalen zugehörigen Ausgabewert assoziiert ist.

13. Verfahren nach Anspruch 12, wobei der minimale zugehörige Ausgabewert einem minimalen Intermodulationsprodukt zweiter Ordnung enspricht.

14. Verfahren nach einem der Ansprüche 11 bis 13, wobei das Verfahren zum Trimmen eines Intermodulationsschnittpunkts zweiter Ordnung (IIP2) verwendet wird.

15. Verfahren nach Anspruch 14, weiterhin aufweisend:

Verwenden von Ausgabe-Gleichstrom-Offset-Komponenten von aktiven Mixer-Schaltungen als Kriterium zum Trimmen des IIP2 einer Gilbert-Zelle.

**Revendications**

1. Circuit pour réduire la distorsion d'intermodulation dans un dispositif non linéaire (10) ayant un étage de sortie différentiel, le circuit comprenant :

des moyens de génération de décalage (20) pour générer une tension de décalage d'étalonnage; et
des moyens d'étalonnage (20) pour ajouter la tension de décalage d'étalonnage à au moins l'une d'une branche de sortie de l'étage de sortie différentiel et d'une borne de substrat d'un transistor d'une branche de sortie de l'étage de sortie différentiel, afin d'obtenir un décalage de sortie souhaité au niveau de l'étage de sortie différentiel.

2. Circuit selon la revendication 1, comprenant en outre des moyens de mémoire (30) pour mémoriser une pluralité de valeurs de tension de décalage, le circuit étant apte à sélectionner en tant que tension de décalage d'étalonnage une valeur de tension de décalage associée à une valeur de sortie associée minimum.

3. Circuit selon la revendication 2, dans lequel la valeur de sortie associée minimum correspond à un produit d'intermodulation du second ordre minimum.

4. Circuit selon l'une quelconque des revendications précédentes, comprenant en outre des moyens de détection (20) pour détecter une tension de décalage au niveau d'une sortie de l'étage de sortie différentiel.

5. Circuit selon la revendication 4, comprenant en outre des moyens de mémoire (30) pour mémoriser une valeur d'une tension de décalage souhaitée, dans lequel les moyens de génération de décalage (20) sont aptes à lire ladite valeur de tension de décalage souhaitée et à générer la tension de décalage d'étalonnage à une valeur requise pour obtenir ladite valeur lue au niveau de l'étage de sortie différentiel à sortie décalée.

6. Circuit selon l'une quelconque des revendications 1 à 4, comprenant en outre des moyens de mémoire (30) pour mémoriser une valeur de la tension de décalage d'étalonnage, dans lequel les moyens de génération de décalage (20) sont aptes à lire la valeur de tension de décalage d'étalonnage et à générer la tension de décalage d'étalonnage à une valeur correspondant à ladite valeur lue.

7. Circuit selon l'une quelconque des revendications précédentes, dans lequel le dispositif non linéaire est un circuit mélangeur (10).

8. Circuit selon l'une quelconque des revendications précédentes, dans lequel les moyens de génération de décalage (10) comprennent des moyens de résistance auxquels est fourni un courant provenant d'un convertisseur numérique-analogique.

9. Circuit selon l'une quelconque des revendications précédentes, dans lequel la tension de décalage d'étalonnage est ajoutée à l'une des tensions d'alimentation d'un des transistors d'une paire de transistors.

10. Circuit selon la revendication 9, dans lequel la tension de décalage d'étalonnage est ajoutée à une tension de substrat dudit un transistor de la paire de transistors.

11. Procédé pour réduire la distorsion d'intermodulation dans un dispositif non linéaire (10) ayant un étage de sortie différentiel, le procédé comprenant les étapes suivantes:

   générer une tension de décalage d'étalonnage; et
   ajouter la tension de décalage d'étalonnage à au moins l'une d'une branche de sortie de l'étage de sortie différentiel et d'une borne de substrat d'un transistor d'une branche de sortie de l'étage de sortie différentiel, afin d'obtenir un décalage de sortie souhaité au niveau de l'étage de sortie différentiel.

12. Procédé selon la revendication 11, comprenant en outre la mémorisation d'une pluralité de valeurs de tension de décalage, et la sélection d'une valeur de tension de décalage d'étalonnage associée à la valeur de sortie associée minimum.

13. Procédé selon la revendication 12, dans lequel la valeur de sortie associée minimum correspond à un produit d'intermodulation du second ordre minimum.

14. Procédé selon l'une quelconque des revendications 11 à 13, le procédé étant utilisé pour ajuster un point d'interception d'intermodulation du second ordre (IIP2).

15. Procédé selon la revendication 14, comprenant en outre l'utilisation de composants de décalage en tension continue de sortie de circuit mélangeurs actifs en tant que critères pour ajuster le point IIP2 d'une cellule de Gilbert.

FIG. 1

FIG. 2

FIG. 3

FIG. 4

FIG. 5

```
        ┌──────────────────────────────────────┐
        │        Set bulk offset voltage       │──── S101
        └──────────────────────────────────────┘
                          │
                          ▼
        ┌──────────────────────────────────────┐
        │         Measure IM2 product          │──── S102
        └──────────────────────────────────────┘
                          │
                          ▼
        ┌──────────────────────────────────────┐
        │   Store offset value for minimum     │──── S103
        │            IM2 product               │
        └──────────────────────────────────────┘
                          │                S104
                          ▼
                   ◇─────────────◇
                   │ End of range? │
                   ◇─────────────◇
                          │
                          ▼
        ┌──────────────────────────────────────┐
        │      Apply stored offset voltage     │──── S105
        └──────────────────────────────────────┘
```

# FIG. 6

FIG. 7

**REFERENCES CITED IN THE DESCRIPTION**

**Patent documents cited in the description**

- US 20050143044 A1

- WO 2005112251 A

**Non-patent literature cited in the description**

- **M. Hotti et al.** An IIP2 Calibration Technique for Direct Conversion Receivers. *ISCAS 2004, IEEE,* 2004, IV-257-260
- **S. Zhou et al.** A CMOS Passive Mixer with Low Flicker Noise for Low-Power Direct-Conversion Receiver. *IEEE, Solid-State Circuits,* May 2005, vol. 40 (5

- **E. Bautista.** A High IIP2 Down Conversion Mixer Using Dynamic Matching. *IEEE, Solid-State Circuits,* December 2000, vol. 35 (12